# DEMANDE DE BREVET EUROPEEN

(11) **EP 1 170 794 A1**
(43) Date de publication de la demande: **09.01.2002**
(21) Numéro de dépôt: 01401764.4
(22) Date de dépôt: 02.07.2001
(51) Int. Cl.: H01L 23/485, H01L 21/60

(54) **Procédé de fabrication d'un composant électronique de puissance, et composant électronique de puissance ainsi obtenu**

(30) Priorité: 07.07.2000 FR 0008931
(71) Demandeur: Alstom, 75116 Paris (FR)
(72) Inventeur: Petitbon, Alain, 64000 Pau (FR); Martin, Nathalie, 65310 Horgues (FR); Jorda, Xavier, 08017 Barcelona (ES); Godignon, Philippe, 08190 Saint Cugat (ES); Flores, David, 08760 Martorell (ES)
(74) Mandataire: Gosse, Michel

(57) **Abrégé**

Selon ce procédé, on dispose successivement sur un substrat (18) au moins une couche conductrice (20) et au moins un circuit semi-conducteur de puissance (2), et on rapporte, sur la face du circuit semi-conducteur (2) opposée à la couche conductrice (20), des plots métalliques (14) de connexion, par dépôt, par métallisation, d'un film métallique (12).

On dispose ensuite au moins un élément de soudage (16) sur le ou chaque film (12) ainsi obtenu, on rapporte au moins un organe conducteur (26) sur le ou chaque élément de soudage (16), à l'opposé du film métallique (12), et on réalise une fusion du ou de chaque élément de soudage, de façon à assujettir le ou chaque organe conducteur (26) avec le ou chaque film métallique (12).

## Description

La présente invention concerne un procédé de fabrication d'un composant électronique de puissance, et un composant électronique de puissance ainsi obtenu.

De manière habituelle, un composant électronique de puissance, qui est en particulier utilisé dans le domaine technique de la traction ferroviaire, comprend un substrat sur lequel sont rapportées plusieurs couches conductrices. Au moins un circuit semi-conducteur de puissance est disposé sur chacune de ces dernières, à savoir par exemple un transistor bipolaire à grille isolée, dit IGBT, ou bien encore une diode.

Chaque circuit semi-conducteur est pourvu, sur sa face opposée à la couche conductrice précitée, de plots métalliques de connexion, sur lesquels sont soudés des fils d'aluminium présentant typiquement un diamètre de 380 à 500 microns. Chacun de ces fils est par ailleurs soudé sur une des couches conductrices recouvrant le substrat.

Ce composant électronique de puissance, de type connu, présente cependant certains inconvénients. En effet, les fils d'aluminium précités sont à l'origine de nombreux problèmes de fiabilité, liés aux contraintes mécaniques s'exerçant au niveau de la soudure entre ces fils et les plots de connexion correspondants.

Par ailleurs, ces fils sont à l'origine d'une inductance parasite susceptible de limiter les performances de l'ensemble du composant électronique de puissance. Enfin, ce dernier ne permet pas une évacuation optimale de la chaleur, puisque cette évacuation est réalisée sur une unique face de ce composant.

Afin de résoudre, dans une certaine mesure, les problèmes précités, on a proposé des connexions de puissance ne faisant pas appel aux fils d'aluminium précités. A cet effet, il est mis en oeuvre un procédé de fabrication par contacts pressés, tel que celui décrit par exemple dans EP-A-0 784 342.

Quand bien même ce procédé de réalisation apporte une solution satisfaisante en termes d'évacuation de la chaleur, il présente d'autres inconvénients, à savoir qu'il implique l'utilisation de mécanismes de pressage compliqués. Par ailleurs, il est peu commode à mettre en oeuvre, dans la mesure où il nécessite des circuits semi-conducteurs spécifiques.

Afin de pallier l'ensemble de ces inconvénients, l'invention vise à proposer un procédé de fabrication d'un composant électronique de puissance, qui est simple et rapide à mettre en oeuvre et permet l'obtention d'un composant électronique robuste et garantissant une évacuation satisfaisante de la chaleur.

A cet effet, elle a pour objet un procédé de fabrication d'un composant électronique de puissance, dans lequel on dispose successivement sur un substrat, au moins une couche conductrice et au moins un circuit semi-conducteur de puissance, et dans lequel on rapporte, sur la face du circuit semi-conducteur opposée à la couche conductrice, des plots métalliques de connexion, caractérisé en ce que l'étape consistant à rapporter lesdits plots de connexion sur ladite face opposée du circuit semi-conducteur comprend une étape de dépôt, par métallisation, d'un film métallique, en ce qu'on dispose au moins un élément de soudage sur le ou chaque film ainsi obtenu, on rapporte au moins un organe conducteur sur le ou chaque élément de soudage, à l'opposé du film métallique, et en ce qu'on réalise une fusion du ou de chaque élément de soudage, de façon à assujettir le ou chaque organe conducteur avec le ou chaque film métallique.

L'invention permet de réaliser les objectifs précédemment mentionnés.

En effet, le procédé de l'invention fait appel à des étapes de réalisation simples et aisées à mettre en oeuvre.

Par ailleurs, le composant ainsi obtenu possède une fiabilité améliorée, dans la mesure où l'assujettissement par soudure permet de réduire, dans une mesure importante, les dilatations différentielles inhérentes à l'emploi antérieur des fils métalliques de connexion.

En outre, le procédé de l'invention assure une évacuation satisfaisante de la chaleur, depuis les deux faces opposées de chaque circuit semi-conducteur.

Enfin, ce procédé est d'une flexibilité notable, dans la mesure où il permet la fabrication de composants électroniques de puissance à partir de circuits semi-conducteurs de natures différentes, sans modification substantielle des étapes de ce procédé.

Selon une première variante de l'invention, on réalise l'étape de dépôt du film métallique directement sur une plaquette semi-conductrice vierge appartenant audit circuit semi-conducteur de puissance.

Selon une seconde variante de l'invention, on réalise l'étape de dépôt dudit film métallique sur un organe de connexion préexistant dudit circuit semi-conducteur.

Un tel organe de connexion est par exemple constitué par une pellicule en aluminium, recouverte d'une couche d'oxyde d'aluminium. Ce mode de réalisation est avantageux, étant donné qu'il permet le traitement de composants classiques de l'art antérieur, voire une valorisation de composants usagés.

Selon une autre caractéristique de l'invention, le film métallique est constitué d'un alliage de titane-nickel.

Selon une autre caractéristique de l'invention, on réalise l'étape de dépôt du film métallique, par métallisation au travers des ouvertures d'un masque. Ceci est avantageux en termes de commodité de fabrication, dans la mesure où ce masque peut être posé directement sur le circuit semi-conducteur que l'on désire revêtir.

Selon une autre caractéristique de l'invention, chaque élément de soudage possède une dimension transversale supérieure à 0,5 mm et, de préférence, supérieure à 1 mm. On entend par dimension transversale, soit le diamètre de cet élément de soudage, soit sa plus grande largeur.

Selon une première variante de l'invention, chaque élément de soudage est constitué par un élément préformé, notamment une bille. Ceci est avantageux, étant donné qu'il peut être aisément procédé à un stockage de ces éléments préformés. Par ailleurs, lors de là fabrication du composant de puissance, ces éléments préformés stockés peuvent être acheminés en direction de chaque film métallique, au travers des ouvertures du masque dont il est fait mention ci-dessus.

Selon une seconde variante de l'invention, chaque élément de soudage est constitué par une dose de matière de soudage.

Selon une autre caractéristique de l'invention, chaque élément de soudage est réalisé en un alliage d'étain-plomb-argent.

Selon un premier mode de réalisation de l'invention, l'étape de fusion du ou de chaque élément de soudage comporte une phase primaire de fusion, permettant d'assujettir chaque élément de soudage sur le film métallique, on rapporte ensuite le ou chaque organe conducteur sur le ou chaque élément de soudage après ladite phase primaire, et il est prévu une phase secondaire de fusion, permettant d'assujettir chaque élément de soudage avec un organe conducteur correspondant. Ce mode de réalisation permet, une fois la phase de fusion primaire mise en oeuvre, de positionner de façon stable chaque élément de soudage sur le plot métallique qu'il recouvre.

Selon un second mode de réalisation de l'invention, on rapporte chaque organe conducteur sur chaque élément de soudage, puis on réalise ladite fusion de cet élément de soudage en une seule étape. Ce mode de réalisation est avantageux en termes de rapidité et de simplicité.

Selon une autre caractéristique avantageuse de l'invention, on assujettit chaque circuit semi-conducteur de puissance sur une couche conductrice correspondante en intercalant, entre ce circuit et cette couche, un film de soudage, puis en opérant une fusion dudit film, ce film et chaque élément de soudage étant réalisés dans le même matériau. Cette mesure garantit une grande commodité de réalisation, et induit de faibles coûts de fabrication.

Selon une caractéristique particulièrement avantageuse de l'invention, on réalise la fusion, d'une part dudit film de soudage et, d'autre part, de chaque élément de soudage, en une unique étape. Cette fusion est par exemple réalisée dans un four, dont la température est comprise en 180 et 300°C.

Cette mesure assure une diminution substantielle du temps de fabrication du composant électronique. En effet, on assujettit en une unique étape, d'une part, chaque circuit semi-conducteur sur une couche conductrice correspondante et, d'autre part, chaque organe conducteur sur le film métallique dont est pourvu ce circuit semi-conducteur.

L'invention a également pour objet un composant électronique de puissance, comprenant un substrat, au moins une couche conductrice supportée par ce substrat, et au moins un premier circuit semi-conducteur de puissance disposé sur ladite couche conductrice et comportant des plots métalliques de connexion assujettis, par leur face opposée au substrat, à au moins un organe conducteur, ledit composant étant réalisé selon le procédé tel que défini ci-dessus.

Selon d'autres caractéristiques de l'invention :
- ce composant comporte au moins deux organes conducteurs isolés entre eux ;
- ces deux organes conducteurs comprennent un émetteur et une grille, dont l'un au moins est commun à plusieurs circuits semi-conducteurs disposés sur ledit substrat ;
- ce composant comporte en outre au moins un circuit semi-conducteur supplémentaire, rapporté sur le ou chaque organe conducteur à l'opposé dudit premier circuit semi-conducteur.

L'invention va être décrite ci-dessous, en référence aux dessins annexés, donnés uniquement à titre d'exemples non limitatifs et dans lesquels :
- les figures 1 à 3 sont des vues, respectivement de côté et de dessus, illustrant trois phases successives de dépôt d'un film métallique, par métallisation, sur un circuit semi-conducteur de puissance ;
- les figures 4 à 6 sont des vues de côté illustrant trois phases successives de l'assujettissement d'un organe conducteur sur le circuit semi-conducteur de puissance des figures 1 à 3 ;
- les figures 7 et 8 sont des vues, respectivement de côté et de dessus, illustrant un premier mode de réalisation d'un composant électronique de puissance obtenu selon l'invention ; et
- les figures 9 à 11 sont des vues de côté illustrant trois variantes de réalisation d'un composant électronique de puissance obtenu selon l'invention.

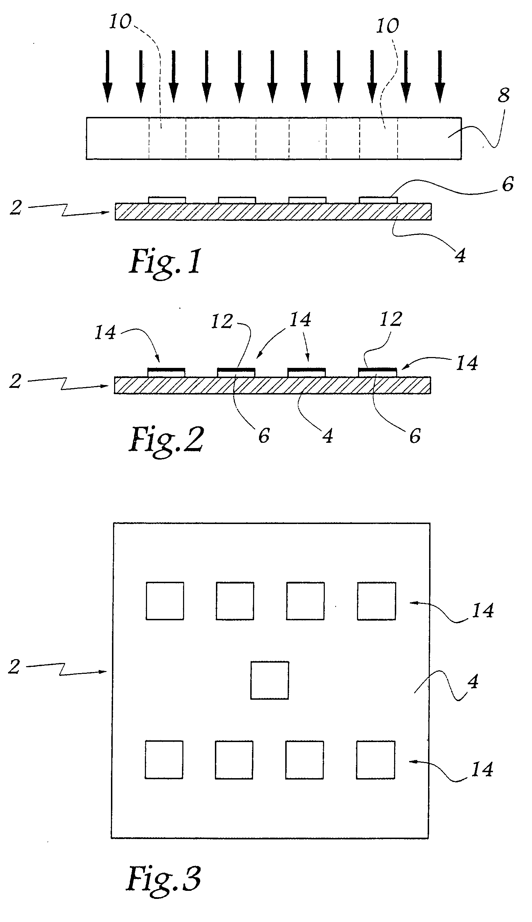

Les figures 1 à 3 illustrent une étape de métallisation d'un circuit semi-conducteur de puissance. Ce dernier, désigné dans son ensemble par la référence 2, comprend une plaquette semi-conductrice 4 surmontée par plusieurs organes de connexion préexistants, à savoir des pellicules 6 visibles à la figure 1. Ces pellicules, réalisées par exemple en aluminium, sont recouvertes d'une couche d'oxyde non représentée, sur leur face opposée à la plaquette 4. Cette couche est formée lors de l'oxydation des pellicules en aluminium, dans l'air ambiant.

L'étape de métallisation consiste tout d'abord à rapporter un masque 8, pourvu d'ouvertures 10, à proximité des pellicules 6. Puis, on procède au revêtement de ces pellicules 6, au travers des ouvertures 10 précitées. Cette métallisation est effectuée de façon connue, par exemple par évaporation thermique, ou bien encore par évaporation par faisceaux d'électrons ou analogue. Le métal mis en oeuvre est par exemple un alliage titane-nickel.

Cette étape de revêtement conduit à la formation d'un film métallique 12, s'étendant au-dessus de la couche d'oxyde recouvrant chaque pellicule. Cette pellicule 6 et ce film 12 forment un plot métallique de connexion, désigné dans son ensemble par la référence 14.

A titre de variante, on peut déposer le masque 8 directement à la surface de la plaquette 4, de sorte que les ouvertures 10 débouchent à la surface libre des pellicules 6. On peut également effectuer l'étape de métallisation directement sur une plaquette semi-conductrice vierge, analogue à celle 4 des figures 1 à 3.

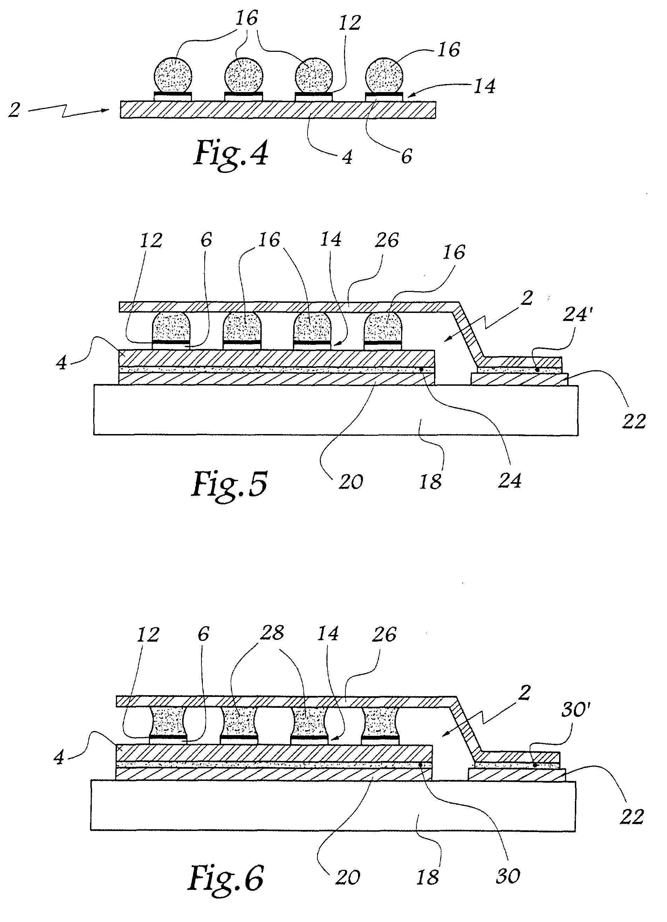

Les figures 4 à 6 illustrent des phases de soudage, permettant d'assujettir le circuit semi-conducteur 2 avec un organe conducteur rapporté.

Dans un premier temps, comme l'illustre la figure 4, on rapporte un élément de soudage 16, qui est une bille, sur chaque plot 14 formé selon l'étape illustrée aux figures 2 et 3. Ces billes 16 sont avantageusement acheminées en direction des plots 14, au travers des ouvertures 10 du masque 8, non représenté sur cette figure 4.

On procède ensuite à une fusion primaire de chaque bille 16, qui est par exemple réalisée en un alliage d'étain-plomb-argent, de façon à l'assujettir au plot 14.

Puis, comme l'illustre la figure 5, il s'agit de rapporter ce circuit semi-conducteur 2 sur un substrat 18. Ce dernier reçoit, de façon connue, une couche conductrice 20 et une piste conductrice 22, cette couche et cette piste étant isolées entre elles.

On recouvre alors les faces, opposées au substrat 18, de la couche 20 et de la piste 22 au moyen de films de soudage 24, 24' réalisés dans le même alliage que les billes 16. On dispose alors le circuit 2, surmonté des billes 16, sur le film de soudage 24, ainsi qu'un organe conducteur 26 sur la face des billes 16 opposée au circuit 2. Cet organe 26 possède une seconde extrémité que l'on place au-dessus du film de soudage 24' recouvrant la piste 22.

Puis, comme le montre la figure 6, on procède à un chauffage des différents éléments illustrés à la figure 5, de manière à induire la fusion simultanée des billes 16, ainsi que des films 24, 24'. Ceci conduit à la formation d'une première série de soudures 28, de forme à peu près tubulaire, permettant d'assujettir les plots 14 avec l'organe conducteur 26. Le chauffage précité provoque également la formation de soudures planes 30, 30' reliant, d'une part, la couche conductrice 20 au circuit semi-conducteur 2 et, d'autre part, la piste conductrice 22 à la seconde extrémité de l'organe conducteur 26.

A titre de variante, les phases de fusions primaire et secondaire, illustrées respectivement aux figures 5 et 6, peuvent être mises en oeuvre au cours d'une unique étape de fusion. Par ailleurs, les billes de soudage 16 peuvent être remplacées par des doses d'une matière pâteuse de soudage, que l'on délivre au-dessus de chaque plot 14.

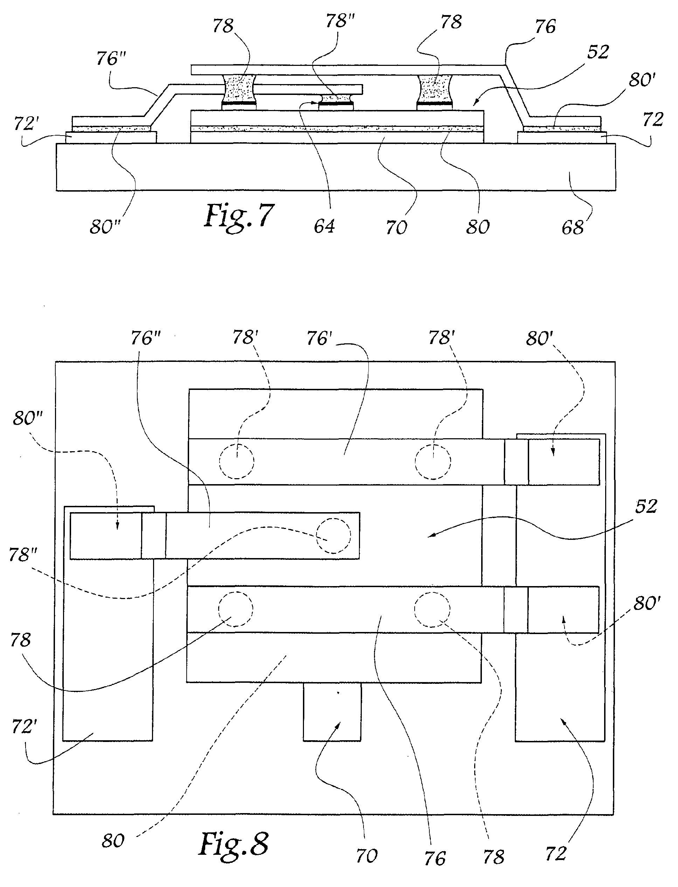

Les figures 7 et 8 illustrent un composant électronique de puissance obtenu selon le procédé décrit en référence aux figures 1 à 6.

Ce composant comprend un substrat 68 sur lequel sont disposées une couche conductrice 70, ainsi que deux pistes conductrices 72, cette couche 70 et ces pistes 72 étant isolées entre elles. Un circuit semi-conducteur de puissance 52 est rapporté au-dessus de la couche 70, avec interposition d'une soudure plane 80.

Des plots 64, qui recouvrent la face du circuit 52 opposée au substrat 68, sont assujettis à trois organes conducteurs 76, 76', 76'' par l'intermédiaire de bossages de soudure 78, 78', 78''. Par ailleurs, les extrémités opposées des organes conducteurs 76 et 76' sont assujetties à la piste conductrice 72, avec interposition de soudures planes 80', alors que l'organe 76'' est assujetti à la piste 72' par une soudure plane 80''.

A titre de variante, les deux organes conducteurs 76 et 76' peuvent être réunis en un unique organe, creusé d'une échancrure de passage de l'organe conducteur 76'', destiné à être isolé de l'organe conducteur unique ainsi formé.

A titre de variante, il est également possible de rapporter un élément de refroidissement sur au moins l'une des faces du composant électronique de puissance. Ainsi, la face libre du substrat 68 et/ou la face libre des organes conducteurs 76, 76', 76'' peut être mise en contact avec un tel élément de refroidissement, de type connu en soi.

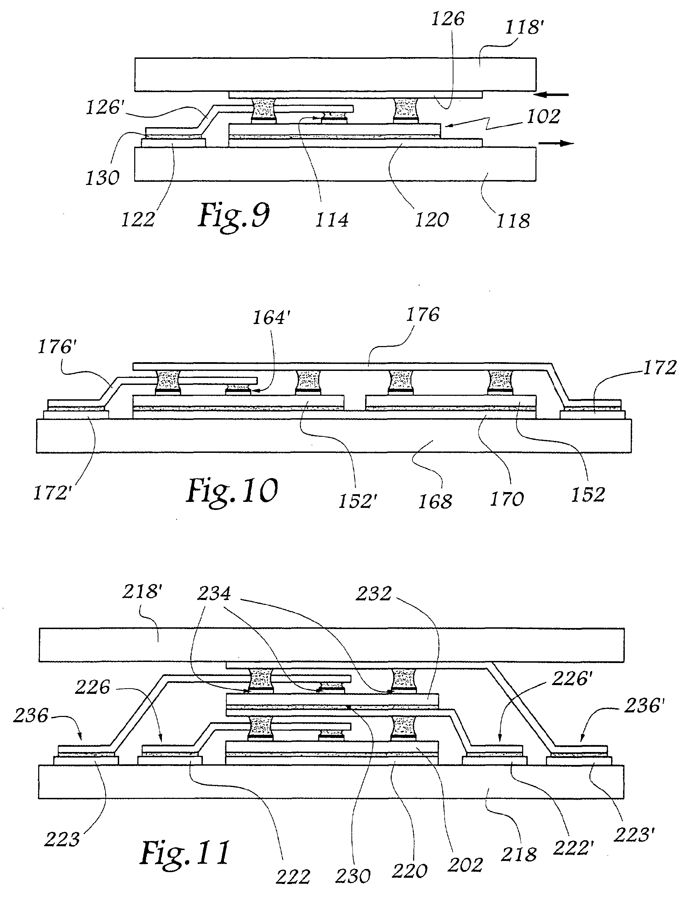

La figure 9 illustre une première variante du composant électronique de puissance de l'invention. Sur cette figure, les éléments mécaniques analogues à ceux des figures 7 et 8 ont été affectés des mêmes numéros de référence, augmentés de 50.

Le composant de la figure 9 comprend un substrat inférieur 118, une couche conductrice 120, une piste conductrice 122, ainsi qu'un circuit semi-conducteur de puissance 102, dont les plots 114 sont reliés à deux organes conducteurs 126, 126'. L'un 126 de ceux-ci est surmonté, à l'opposé du circuit 102, par un substrat supérieur 118', alors que l'autre 126' est relié à la piste conductrice 122, avec interposition d'une soudure plane 130.

La figure 10 illustre une variante supplémentaire de réalisation d'un composant électronique de puissance selon l'invention. Sur cette figure, les éléments analogues à ceux des figures 7 et 8 ont été affectés des mêmes numéros de référence, augmentés de 100.

Le composant de la figure 10 comprend un substrat 168, une couche conductrice 170, deux pistes conductrices 172, 172' ainsi que deux circuits semi-conducteurs de puissance 152, 152'. Un premier organe conducteur 176 est relié à plusieurs des plots des deux circuits semi-conducteur 152, 152' et se trouve également rapporté au-dessus de la piste conductrice 172. Par ailleurs, un second organe conducteur 176' est relié à un plot 164' du second circuit 152', ainsi qu'à la piste conductrice 172'.

Ce composant électronique de puissance permet d'associer un transistor bipolaire à grille isolée, ou IGBT, avec une diode, montés en anti-parallèle. La couche 170 forme un collecteur, ou cathode, l'organe 176 constitue un émetteur, ou anode, alors que l'organe conducteur 176' forme une grille.

A titre de variante, l'organe 176' peut s'étendre plus loin que sur la figure 9, en ce sens qu'il peut être mis en relation avec au moins un plot du premier circuit semi-conducteur 152. Cet agencement permet de former deux IGBT, placés en parallèle.

La figure 11 illustre une variante supplémentaire de réalisation de l'invention, figure sur laquelle les éléments mécaniques analogues à ceux des figures 7 et 8 ont été affectés des mêmes numéros de référence, augmentés de 150.

Le substrat inférieur 218 supporte une couche conductrice 220, ainsi que quatre pistes conductrices 222, 222', 223 et 223'. La couche 220 supporte un premier circuit semi-conducteur 202, dont les plots sont mis en relation avec deux organes conducteurs 226, 226'. L'un 226 de ces organes est assujetti à la piste conductrice 222, alors que l'autre 226' est assujetti à la piste 222'.

Un circuit semi-conducteur supplémentaire 232 est disposé sur l'organe conducteur 226', avec interposition d'une soudure plane 230, analogue à.celle 80 décrite ci-dessus. Les plots 234 du circuit 232 sont mis en relation avec deux organes conducteurs supplémentaires 236, 236', dont l'un 236 est assujetti à la piste 223, alors que l'autre 236' est assujetti à la piste 223'. Un substrat supérieur 218' est enfin rapporté sur la face de l'organe 236' opposée au circuit 232.

L'agencement de la figure 11 permet de constituer deux IGBT en série, dont tous les contacts sont situés sur le substrat inférieur 218. Ainsi, l'organe conducteur 226', l'organe conducteur 236' et l'organe conducteur 236 constituent respectivement le collecteur, l'émetteur et la grille de ce premier IGBT. Par ailleurs, la couche conductrice 220, l'organe conducteur 226' et l'organe conducteur 226 constituent respectivement le collecteur, l'émetteur et la grille du second IGBT.

A titre de variante, on peut prévoir que les organes conducteurs 236, 236' soient mis en contact avec des pistes conductrices placées sur le substrat supérieur 218', et non pas sur le substrat inférieur 218.

## Revendications

1. Procédé de fabrication d'un composant électronique de puissance, dans lequel on dispose successivement sur un substrat (18), au moins une couche conductrice (20) et au moins un circuit semi-conducteur de puissance (2), et dans lequel on rapporte, sur la face du circuit semi-conducteur (2) opposée à la couche conductrice (20), des plots métalliques (14) de connexion, **caractérisé en ce que** l'étape consistant à rapporter lesdits plots de connexion (14) sur ladite face opposée du circuit semi-conducteur (2) comprend une étape de dépôt; par métallisation, d'un film métallique (12), **en ce qu'**on dispose au moins un élément de soudage (16) sur le ou chaque film (12) ainsi obtenu, on rapporte au moins un organe conducteur (26) sur le ou chaque élément de soudage (16), à l'opposé du film métallique (12), et **en ce qu'**on réalise une fusion du ou de chaque élément de soudage, de façon à assujettir le ou chaque organe conducteur (26) avec le ou chaque film métallique (12).

2. Procédé selon la revendication 1, **caractérisé en ce qu'**on réalise l'étape de dépôt du film métallique directement sur une plaquette semi-conductrice vierge appartenant audit circuit semi-conducteur de puissance.

3. Procédé selon la revendication 1, **caractérisé en ce qu'**on réalise l'étape de dépôt dudit film métallique (12) sur un organe de connexion préexistant (6) dudit circuit semi-conducteur (2).

4. Procédé selon l'une des revendications précédentes, **caractérisé en ce que** le film métallique (12) est constitué d'un alliage de titane-nickel.

5. Procédé selon l'une des revendications précédentes, **caractérisé en ce qu'**on réalise l'étape de dépôt du film métallique (12), par métallisation au travers des ouvertures (10) d'un masque (8).

6. Procédé selon l'une des revendications précédentes, **caractérisé en ce que** chaque élément de soudage (16) possède une dimension transversale supérieure à 0,5 mm et, de préférence, supérieure à 1 mm.

7. Procédé selon l'une des revendications précédentes, **caractérisé en ce que** chaque élément de soudage est constitué par un élément préformé, notamment une bille (16).

8. Procédé selon l'une des revendications 1 à 6, **caractérisé en ce que** chaque élément de soudage est constitué par une dose de matière de soudage.

9. Procédé selon l'une des revendications précédentes, **caractérisé en ce que** chaque élément de soudage (16) est réalisé en un alliage d'étain-plomb-argent.

10. Procédé selon l'une des revendications 1 à 9, **caractérisé en ce que** l'étape de fusion du ou de chaque élément de soudage (16) comporte une phase primaire de fusion, permettant d'assujettir chaque élément de soudage (16) sur le film métallique (12), **en ce qu'**on rapporte ensuite le ou chaque organe conducteur (26) sur le ou chaque élément de soudage après ladite phase primaire, et **en ce qu'**il est prévu une phase secondaire de fusion, permettant d'assujettir chaque élément de soudage (16) avec un organe conducteur (26) correspondant.

11. Procédé selon l'une des revendications 1 à 9, **caractérisé en ce qu'**on rapporte chaque organe conducteur sur chaque élément de soudage, puis on réalise ladite fusion de cet élément de soudage en une seule étape.

12. Procédé selon l'une des revendications précédentes, **caractérisé en ce qu'**on assujettit chaque circuit semi-conducteur de puissance (2) sur une couche conductrice (20) correspondante en intercalant, entre ce circuit (2) et cette couche (20), un film de soudage (24) puis, en opérant une fusion dudit film, ce film (24) et chaque élément de soudage (16) étant réalisés dans le même matériau.

13. Procédé selon la revendication 12, **caractérisé en ce qu'**on réalise la fusion, d'une part dudit film de soudage (24) et, d'autre part, de chaque élément de soudage (16), en une unique étape.

14. Composant électronique de puissance, comprenant un substrat (68 ; 118 ; 168 ; 218), au moins une couche conductrice (70 ; 120 ; 170 ; 220) supportée par ce substrat, et au moins un premier circuit semi-conducteur de puissance (52 ; 102 ; 152, 152' ; 202) disposé sur ladite couche conductrice et comportant des plots métalliques (64 ; 114 ; 164, 164' ; 214) de connexion assujettis, par leur face opposée au substrat, à au moins un organe conducteur (76, 76', 76" ; 126, 126' ; 176, 176' ; 226, 226'), ledit composant étant réalisé selon le procédé conforme à l'une quelconque des revendications précédentes.

15. Composant selon la revendication 14, **caractérisé en ce qu'**il comporte au moins deux organes conducteurs (76, 76', 76'' ; 126, 126' ; 176, 176' ; 226, 226') isolés entre eux.

16. Composant selon la revendication 15, **caractérisé en ce que** ces deux organes conducteurs comprennent un émetteur (176) et une grille (176'), dont l'un (176) au moins est commun à plusieurs circuits semi-conducteurs (152, 152') disposés sur ledit substrat (168).

17. Composant selon la revendication 14 ou 15, **caractérisé en ce qu'**il comporte en outre au moins un circuit semi-conducteur supplémentaire (232), rapporté sur le ou chaque organe conducteur (226') à l'opposé dudit premier circuit semi-conducteur (202).
